# EUROPÄISCHE PATENTSCHRIFT

(11) **EP 0 401 679 B1**
(45) Veröffentlichungstag und Bekanntmachung des Hinweises auf die Patenterteilung: **03.08.1994**
(21) Anmeldenummer: 90110335.8
(22) Anmeldetag: 31.05.1990
(51) Int. Cl.: B05B 13/02, B65G 47/252

(54) **Verfahren und Vorrichtung zum elektrostatischen Aufsprühen einer Flüssigkeitsschicht auf ein Substrat und zum Trocknen der Flüssigkeitsschicht auf dem Substrat**
Process and apparatus for electrostatically applying a liquid layer on a substrate and for drying the liquid layer on the substrate
Procédé et dispositif d'application électrostatique d'une couche de fluide sur un substrat et du séchage de la couche de fluide sur le substrat

(30) Priorität: 07.06.1989 DE 3918559
(43) Veröffentlichungstag der Anmeldung: 12.12.1990
(73) Patentinhaber: HOECHST AKTIENGESELLSCHAFT, 65926 Frankfurt am Main (DE)
(72) Erfinder: Nies, Reinhard, Dipl.-Ing., D-2000 Hamburg 54 (DE); Idstein, Hermann, D-6227 Oestrich-Winkel (DE); Becker, Reinhold, Dr., Dipl.-Ing., D-6200 Wiesbaden (DE); Hultzsch, Günther, Dr., Dipl.-Chem., D.6200 Wiesbaden (DE)

(56) Entgegenhaltungen:
- EP-A- 0 195 041
- FR-A- 2 310 808

## Beschreibung

Die Erfindung betrifft ein Verfahren zum elektrostatischen Aufsprühen einer Flüssigkeitsschicht auf ein Substrat und zum Trocknen der Flüssigkeitsschicht auf dem Substrat, das während des Aufbringens und Trocknens der Flüssigkeitsschicht horizontal transportiert wird, wobei eine Seite des Substrats, das in Förderrichtung A transportiert wird, mit Flüssigkeit besprüht und getrocknet wird, und eine entsprechende Vorrichtung.

Leiterplatten werden im allgemeinen durch Trockenfilm-Laminieren oder durch Naßlackieren von Flüssigresist hergestellt. Die Resist-Lackierverfahren sind Tauchziehen, Walzen, Gießen, Siebdruck und, insbesondere für die Lackierung von Dünnlaminaten, elektrostatische Sprühverfahren.

Das Prinzip des elektrostatischen Sprühverfahrens besteht darin, Flüssigresist an einem Sprühorgan in feinste Tröpfchen zu zerteilen, diese durch Hochspannung elektrisch aufzuladen und auf einem geerdeten Werkstück bzw. Substrat abzuscheiden. Auf der Oberfläche des Substrats verlaufen die Tröpfchen zu einem Naßfilm, der anschließend getrocknet wird.

Aus der EP-B-0 195 041 ist ein elektrostatisches Sprühverfahren für die Leiterplattenlackierung bekannt, bei dem das Substrat im wesentlichen senkrecht zur Richtung der Sprühvorrichtung in einem elektrostatischen Feld bewegt wird, das durch einen Hochspannungsgenerator erzeugt wird. Der Flüssigresist wird in Richtung des Substrats gesprüht, das durch ein Transportband getragen wird, welches ein elektrostatisches Feld durchquert. Eine Elektrode der elektrostatischen Vorrichtung ist an Masse angeschlossen, während die Sprühvorrichtung für den Flüssigresist mit der Hochspannungselektrode eines Stromgenerators verbunden ist. Als Transportmittel für das Substrat wird ein Papierband verwendet. Die Sprüheinrichtung besteht aus einer Luftturbine, der speziell für Flüssigresist entwickelten Sprühglocke, und den Einrichtungen für die Lackzufuhr. Die Sprühglocke wird beispielsweise mit negativer Gleichspannung im Bereich von 40 bis 90 kV aufgeladen.

Für die Leiterplatten-Beschichtung werden Kompaktsysteme bzw. Kompaktanlagen verwendet, wobei die Kammer, durch die das Substrat während des elektrostatischen Aufsprühens des Flüssigresists hindurchgeführt wird, mit Kunststoff ausgekleidet ist. Beim Sprühvorgang laden sich die Wände auf und stoßen die negativ geladenen Tröpfchen von der Wand ab. Mit dem Papierband als Förderband werden Fotoresisttröpfchen, die sich neben oder zwischen den Leiterplatten niederschlagen, aus der Kamner entfernt. Das mitlackierte Papierband wird angetrocknet und als Abfall entfernt. Damit entfällt die Reinigung der Transportvorrichtungen durch die Kammer, und es gibt keinen Naßabfall. Der Flüssigresist wird mit einer regelbaren Dosierpumpe aus einem Resistbehälter auf die Innenseite der Sprühglocke gegeben. Die Lackierbreite kann durch automatische Höhenverstellung der Sprühglocke oder durch Einsatz von Hilfselektroden kontinuierlich im erwünschten Bereich von 250 bis 650 mm verändert und damit an die Substratbreite angepaßt werden. An die Sprühkammer schließt sich eine Abdunststrecke von 1 bis 2 m Länge und danach die Trocknerzone an, die in mehrere Abschnitte unterteilt und geregelt werden kann. Bei Bedarf ist auch eine Kühlstrecke vorgesehen.

Bei dem bekannten Verfahren und der hierfür eingesetzten Vorrichtung ergibt sich eine verhältnismäßig lange Verarbeitungszeit, wenn beide Seiten eines Substrats mit Flüssigresist beschichtet werden sollen. Von Nachteil ist dabei, daß die zuerst beschichtete Substratseite beim zweiten Durchlauf des Substrats über die Förderstrecke im Trockner der Beschichtungsanlage verprägt werden kann, da es für die beidseitige Beschichtung notwendig ist, das zunächst einseitig lackierte Substrat der Beschichtungsvorrichtung zu entnehmen, zu wenden und an der Aufgabeseite in die Beschichtungsvorrichtung von neuem einzugeben. Beim zweiten Durchlauf des Substrats kann dann der Fall eintreten, daß in der Trocknungskammer die nach unten weisende, angetrocknete Resistschicht durch die Wärmeeinwirkung in der Trocknungskammer wieder weich wird, so daß es zu den voranstehend erwähnten Verprägungen kommen kann. Mit der bekannten Vorrichtung ist somit ein vollkontinuierlicher Beschichtungsbetrieb für das beidseitige Beschichten von Substraten für Leiterplatten oder bereits strukturierten Leiterplatten nicht möglich.

Aus der FR-A-2 310 808 sind ein verfahren und eine Vorrichtung zum Zerstäuben eines Überzugs auf einer Seite eines Gegenstandes bekannt, wobei der einseitig beschichtete Gegenstand von einem schräg angeordneten Endlosband in einem Trocknungstunnel hochbefördert wird. Beim Verlassen des Endlosbandes wird der Gegenstand um 180° in der Vertikalen gewendet und gelangt in einen Rückführkanal, wobei die beschichtete Seite mit dem Rückführkanal in Berührung gelangt und der Gegenstand in dem schrägen, unterhalb des Trocknungstunnels angeordneten Rückführkanal nach unten in Richtung seines Ausgangspunktes rutscht. Dort angelangt, wird der Gegenstand wieder auf das Endlosband gehoben, die andere Seite durch Zerstäuben beschichtet und der Trocknungstunnel neuerlich durchlaufen, um auch die zweite beschichtete Seite zu trocknen. Wegen des Schrägtransports des Gegenstandes ist ein elektrostatisches Ansprühen einer Flüssigkeitsschicht, wie eines Flüssigresists, nicht möglich, da es während des Transports des Gegenstandes zu Dickenungleichmäßigkeiten käme, die einen funktionsgerechten Einsatz von fotoresistbeschichteten Gegenständen, wie Leiterplatten, nicht zulassen.

Aufgabe der Erfindung ist es, ein Verfahren und eine Vorrichtung zum beidseitigen Beschichten von Substraten unterschiedlicher Größen mit Flüssigkeit, insbesondere mit Flüssigresist, im vollkontinuierlichen Durchlauf zu schaffen, ohne daß Schäden an den angetrockneten Flüssigkeitsschichten während des Beschichtens entstehen.

Diese Aufgabe wird verfahrensgemäß in der Weise gelöst, daß das Substrat in eine zur ursprünglichen Förderrichtung A entgegengesetzte Förderrichtung B herumgeführt wird, daß das Substrat in der Förderrichtung B in der Vertikalen um 180° gewendet wird, so daß die andere Seite des Substrats nach oben weist, daß aus dieser Förderrichtung B in eine zur ursprünglichen Förderrichtung A des Substrats parallele Förderrichtung C gewechselt, die andere Seite mit Flüssigkeit besprüht, getrocknet und danach das beidseitig beschichtete und getrocknete Substrat abgelegt wird und daß alle Änderungen der Förderrichtungen und das Wenden des Substrats im vollkontinuierlichen Durchlauf erfolgen.

In Weiterführung des Verfahrens durchläuft das Substrat drei Transportlinien einer Vorrichtung, wobei von der ersten zur zweiten und von der zweiten zur dritten Transportlinie jeweils beim Durchlaufen einer ersten und zweiten Förderstation die Förderrichtung gewechselt wird. Zweckmäßigerweise wird in der dritten Transportlinie das Substrat durch eine Trockenkammer, auf einem Luftkissen freischwebend und an einem Ende angeschoben, hindurchgeführt. Dabei steigt im Bereich der zweiten Trocknungskammer die Förderrichtung C des Substrats gegenüber der Horizontalen um einen Winkel von 1 bis 2° an.

In der einen Variante des Verfahrens liegen zwei Transportlinien der Vorrichtung auf gleicher Höhe bzw. in einer Ebene, und die dritte Transportlinie oberhalb dieser Ebene, während in einer anderen Variante des Verfahrens das Substrat drei Transportlinien der Vorrichtung durchläuft, von denen die erste und dritte Transportlinie nebeneinander in einer Horizontalebene sich befinden und die zweite Transportlinie unterhalb der ersten Transportlinie liegt, und beim Übergang des Substrats von der ersten auf die zweite und von der zweiten auf die dritte Transportlinie jeweils als Förderstation ein Serpentinenförderer durchlaufen wird. Bei der letzteren Variante des Verfahrens wird die Flüssigkeitsschicht des Substrats in dem einen Serpentinenförderer, der von der ersten zur zweiten Transportlinie führt, während des Durchlaufs des Substrats getrocknet.

Eine Vorrichtung zur Durchführung des Verfahrens, mit zumindest einer Sprühstation, die mit einem Anschluß eines Hochspannungsgenerators verbunden ist, und mit Förderbändern zum Transportieren des Substrats durch die einzelnen Stationen und Kammern der Vorrichtung, zeichnet sich dadurch aus, daß die Vorrichtung aus einer ersten bis dritten Transportlinie besteht, die durch Förderstationen miteinander verbunden sind, daß in der ersten und dritten Transportlinie je eine Reinigungsstation, eine Sprühstation mit einer Sprüheinrichtung zum Aufsprühen der Flüssigkeitsschicht, eine Antrocknungszone und eine Trocknungskammer hintereinander angeordnet sind, und daß in der zweiten Transportlinie eine Wendestation vorhanden ist, die das Substrat in der Vertikalen um 180° wendet, so daß die Substratunterseite nach oben zu liegen kommt.

Die weitere Ausgestaltung der Vorrichtung ergibt sich aus den Merkmalen der Patentansprüche 8 bis 18.

Mit der Erfindung wird der Vorteil erzielt, daß zunächst eine Substratseite durch elektrostatisches Sprühen mit einer Flüssigkeitsschicht, insbesondere mit Flüssigresist, beschichtet und anschließend getrocknet wird, danach durch spezielle Förderstationen das Substrat an seine Aufgabestelle in der Beschichtungsvorrichtung zurückgeführt und vorher gewendet wird, und danach ein erneutes Durchlaufen von Sprühstation und Trocknungskammer direkt neben der ersten Durchlaufstrecke auf einem Luftkissen erfolgt, wodurch sichergestellt ist, daß es auf der nach unten weisenden, schon beschichteten Substratseite zu keinen Verprägungen beim Durchlauf einer weiteren Trocknungskammer kommen kann. Infolge des vollkontinuierlichen Durchlaufs der einzelnen Substrate wird eine erhebliche Zeitersparnis im Vergleich zu einem Verfahren erzielt, bei dem das einseitig beschichtete Substrat manuell gewendet und die Beschichtungsvorrichtung ein zweites Mal zum Beschichten der noch freien Seite durchläuft.

Die Erfindung wird im folgenden anhand der in den Zeichnungen dargestellten zwei Ausführungsformen einer Beschichtungsvorrichtung näher erläutert. Es zeigen:
- Figur 1: eine Draufsicht auf eine schematisch dargestellte Ausführungsform der Vorrichtung zum beidseitigen Beschichten eines Substrats mit einer Flüssigkeit, nach der Erfindung,
- Figuren 2 bis 4: Je einen Längsschnitt durch eine erste bis dritte Transportlinie der Vorrichtung nach Figur 1,
- Figur 5: in vergrößerter Ansicht einen Ausschnitt einer Trocknungskammer in der dritten Transportlinie der Vorrichtung nach Figur 1,
- Figur 6: in vergrößerter Ansicht einen weiteren Ausschnitt der Trocknungskammer und eines Ablagekastens für die Substrate in der dritten Transportlinie der Vorrichtung nach Figur 1,
- Figur 7: einen Schnitt durch eine Saugwalze einer Wendestation der Vorrichtung nach Figur 1,
- Figur 8: eine Draufsicht auf eine schematisch dargestellte weitere Ausführungsform der Vorrichtung zum beidseitigen Beschichten eines Substrats mit einer Flüssigkeit, nach der Erfindung,
- Figur 9: einen Längsschnitt durch die Vorrichtung nach Figur 8, und
- Figur 10: schematisch den Materialfluß durch die Vorrichtung nach Figur 8.

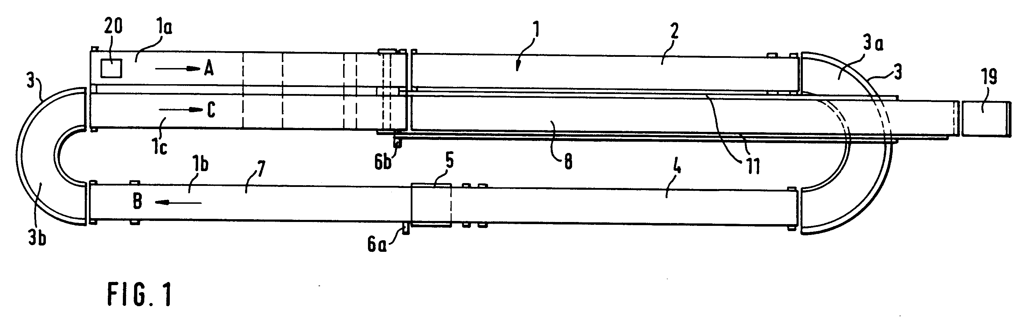

Wie die Draufsicht in Figur 1 zeigt, besteht eine Vorrichtung 1 aus einer ersten bis dritten Transportlinie 1a, 1b und 1c, die parallel zueinander angeordnet sind. Die erste und die zweite Transportlinie sind durch eine Förderstation 3, bestehend aus einem Gurtförderer 3a von halbkreisförmiger Gestalt auf gleicher Höhe miteinander verbunden. In ähnlicher Weise sind die zweite und die dritte Transportlinie durch eine Förderstation 3 in Gestalt eines halbkreisförmigen Gurtförderers 3b miteinander verbunden. Der Durchmesser des Gurtförderers 3a ist größer als derjenige des Gurtförderers 3b. Die dritte Transportlinie 1c verläuft knapp oberhalb der beiden übrigen Transportlinien, um ein Substrat 20 auf dem ersten Gurtförderer 3a unter einem Staukasten 13 in der dritten Transportlinie 1c hindurchtransportieren zu können.

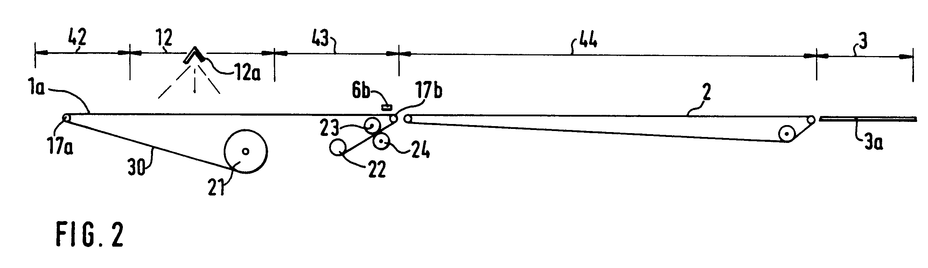

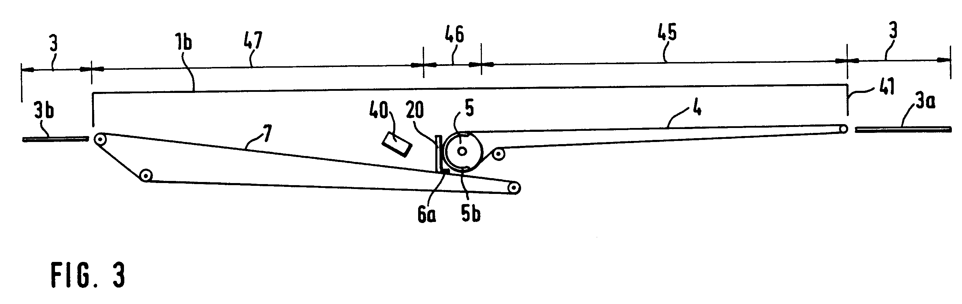

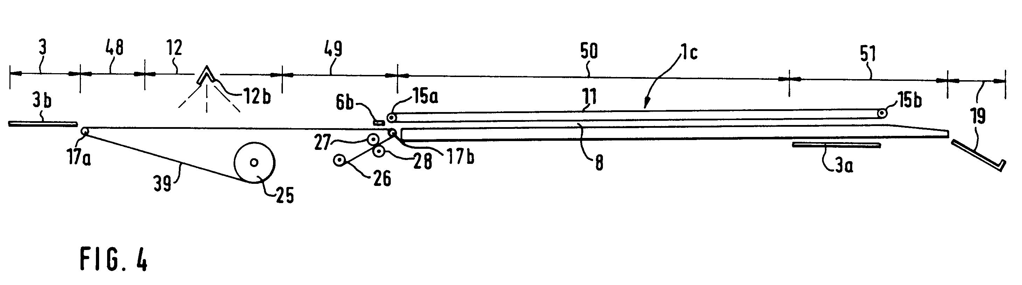

Die beidseitig zu beschichtenden Substrate 20 für Leiterplatten werden von Hand oder automatisch in beliebiger Reihenfolge unter Einhaltung eines Mindestabstandes von beispielsweise 15 mm in einer Aufgabe- und Reinigungsstation 42 auf eine in Förderrichtung A bewegte Papierbahn 30 (vgl. Figur 2) aufgelegt. Die Papierbahn 30 ist gleichzeitig Transportband für die Substrate. Von der Papierbahn 30 gelangt das Substrat 20 auf ein hitzebeständiges Förderband 2 und von diesem auf den Gurtförderer 3a. Dieser übergibt das Substrat 20 an ein gelochtes Förderband 4, das um eine Saugwalze 5 (vgl. Figur 3) herumgeführt ist. Nahe der Saugwalze 5 befindet sich ein Sensor 6a, während ein weiterer Sensor 6b an der Übergangsstelle zwischen der Papierbahn 30 und dem Förderband 2 angeordnet ist. Von der Saugwalze 5 wird das Substrat an ein schräges Förderband 7 übergeben, und in Förderrichtung B, entgegengesetzt und parallel zu Förderrichtung A, gelangt das Substrat auf den Gurtförderer 3b und wird von diesem in Förderrichtung C parallel zu Förderrichtung A an eine weitere Papierbahn 39 (vgl. Figur 4) übergeben, die gleichfalls als endliches Transportband dient. Von der Papierbahn 39 gelangt das Substrat in eine Trocknungskammer 50 und wird von einem Luftkissen 8 bis in einen Ablagekasten 19 transportiert. In der Trocknungskammer 50 befindet sich desweiteren ein Magnetband 11, das nachstehend noch näher beschrieben werden wird.

Wie Figur 2 zeigt, besteht die erste Transportlinie 1a aus der Aufgabe- und Reinigungsstation 42, einer Sprühstation 12 mit einer Sprüheinrichtung 12a, beispielsweise einer Sprühglocke oder einem Sprühkopf, einer ersten Antrocknungszone 43, einer ersten Trocknungskammer 44 und der Förderstation 3 mit dem schon erwähnten Gurtförderer 3a zum ersten horizontalen Drehen des Substrats 20 um 180° in der Horizontalebene. Die Papierbahn 30 wird von einer Abwickelrolle 21 abgezogen und horizontal durch die erste Reinigungsstation 42, die erste Sprühstation 12 und die erste Antrocknungszone 43 hindurchgeführt und läuft dabei über Umlenkrollen 17a und 17b. Nach der Umlenkrolle 17b wird die Papierbahn 30 durch den Spalt eines Transportwalzenpaares 23, 24 hindurchgeführt und auf eine Aufwickelrolle 22 aufgewickelt. Die Papierbahn 30 fördert die Substrate 20 unter der Sprüheinrichtung 12a hindurch und kann aufgrund der Verunreinigungen durch die aufgesprühte Flüssigkeit nicht wieder verwendet werden. Sobald die Papierbahn 30 abgewickelt und weitgehend auf der Aufwickelrolle 22 aufgewickelt ist, wird sie durch eine frische Papierbahn ersetzt. In der ersten Antrocknungszone 43 wird die besprühte Substratoberseite angetrocknet und nach der Übergabe auf das hitzebeständige Förderband 2 in der Trocknungskammer 44 getrocknet.

In der kombinierten (Aufgabe- und Reinigungsstation 42 sind beispielsweise Bürsteinrichtungen und/oder Druckluft-Blasdüsen vorhanden, die mit ionisierter Luft gespeist werden und dementsprechend Staubpartikel entfernen, die durch elektrostatische Effekte auf den Substraten anhaften.

Nach dem ersten Drehen des Substrats 20 in horizontaler Ebene mittels des Gurtförderers 3a erfolgt die Übergabe auf die in Figur 3 gezeigte zweite Transportlinie 1b. Diese besteht aus einer ersten Kühlzone 45, der Wendestation 46, der Transportzone 47 und der Förderstation 3 zum weiteren horizontalen Drehen der Substrate. Die erste Kühlzone 45, die vertikale Wendestation 46 und die Transportzone 47 befinden sich in einem gemeinsamen Kanal 41, der mit reiner gekühlter Luft beaufschlagt ist. In der Kühlzone 45 befindet sich ein gelochtes, endlos umlaufendes Förderband 4, das um die Saugwalze 5 herumgeführt ist, die Bestandteil der Wendestation 46 ist. Die Saugwalze kann zylindrische Gestalt besitzen oder auch die Gestalt eines Polygons, das eine entsprechende Polygonoberfläche mit vorgegebener Segmentlänge aufweist. Die Oberfläche der Saugwalze 5 ist gelocht, und im Inneren der Saugwalze 5 herrscht Unterdruck, so daß jedes Substrat 20, das mittels des gelochten Förderbandes 4 um die Oberfläche der Saugwalze 5 herumgeführt wird, durch den herrschenden Unterdruck im Umschlingungsbereich des Förderbandes um die Saugwalze 5 herum angesaugt wird. Durch die Saugwalze 5 werden die Substrate 20 vertikal gewendet, wie aus Figur 3 ersichtlich ist, in der die Vertikalstellung eines Substrats 20 eingezeichnet ist. Der Sensor 6a erfaßt die Vorderkante des vertikal hochgestellten Substrats 20 und löst einen Druckluftstoß in der Saugwalze 5 oder in einer schräg oberhalb der Saugwalze 5 befindlichen Luftdüse 40 aus. Dieser Druckluftstoß kippt das um die Umfangsfläche der Saugwalze herumgeführte Substrat über bzw. wendet es, so daß die bisher unten liegende Seite des Substrats 20 nach oben auf ein Förderband 7 in der Transportzone 47 zu liegen kommt und die schon beschichtete und getrocknete Seite des Substrats 20 nach unten weist. Das Förderband 7 ist ein endlos umlaufendes, mit leichter Steigung von unterhalb der Wendestation 46 nach oben zu dem zweiten Gurtförderer 3b gerichtetes Band.

In der in Figur 4 gezeigten dritten Transportlinie 1c erfolgt ein weiterer Sprühvorgang, bei dem die bisher freie Seite des Substrats beschichtet wird. Die dritte Transportlinie 1c umfaßt eine zweite Reinigungsstation 48, eine weitere Sprühstation 12, eine zweite Antrocknungszone 49, eine zweite Trocknungskammer 50, eine zweite Kühlzone 51 und den Ablagekasten 19 für die beidseitig beschichteten Substrate. Entlang der dritten Transportlinie 1c wird das Substrat 20 auf einer Papierbahn 39 befördert, die als Transportband dient und durch die Reinigungsstation 48, die Sprühstation 12 und die Antrocknungszone 49 hindurchläuft. Die Papierbahn 39 wird von einer Abwickelrolle 25 abgezogen, um eine Umlenkwalze 17a herumgeführt und horizontal durch die voranstehend erwähnten Stationen hindurchgeführt, um anschließend um eine weitere Umlenkrolle 17b, und durch ein Transportwalzenpaar 27, 28 hindurchgeführt, auf eine Aufwickelrolle 26 aufgewickelt zu werden.

Die beiden Papierbahnen 30 und 39 in den Transportlinien 1a und 1c können auch durch ein einzelnes, breites Papierband ersetzt werden. Die zweite Reinigungsstation 48 ist ebenso wie die erste Reinigungsstation 42 ausgerüstet. In den Transportlinien 1a und 1c können jeweils die Reinigungs- und Sprühstationen für beide Substratseiten in einer gemeinsamen Kabine untergebracht werden. Desweiteren können auch die Trocknungskammern 44 und 50 für die beiden Durchläufe eines Substrats in einem gemeinsamen Gehäuse untergebracht werden.

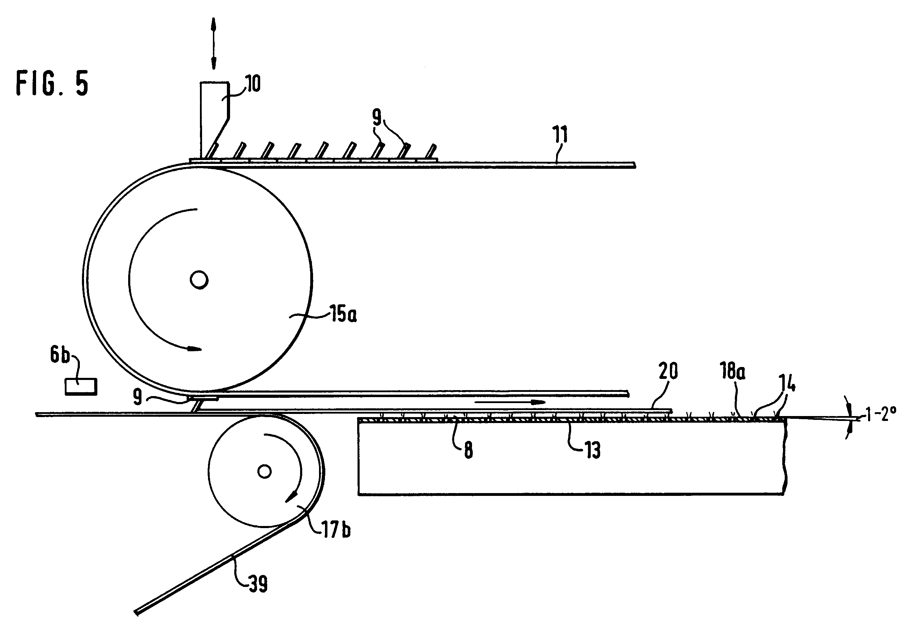

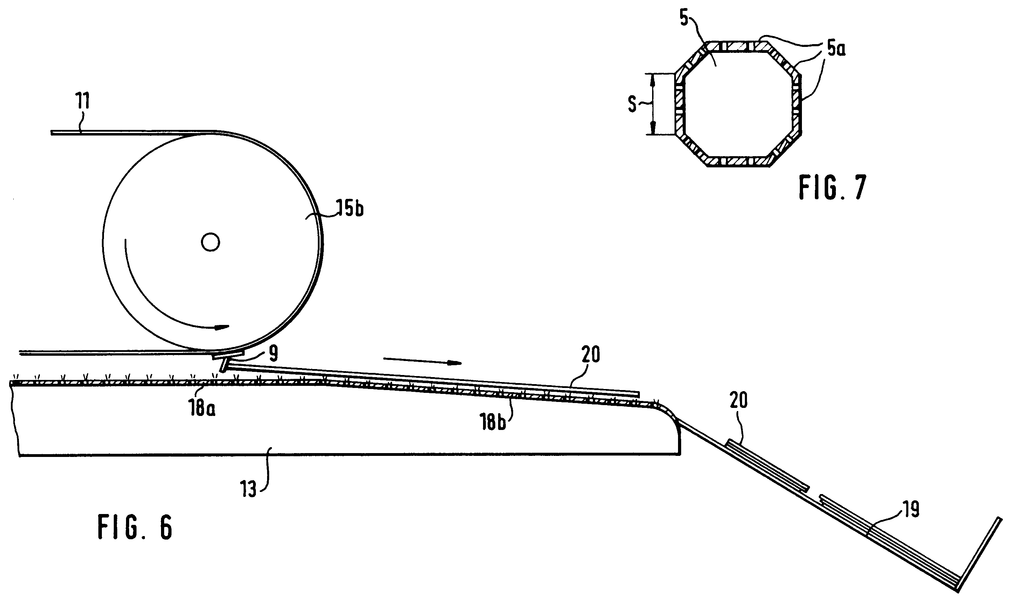

Um die bereits beschichtete Unterseite des Substrats in der zweiten Trocknungskammer 50 nicht zu beschädigen, wird das Substrat an das Luftkissen 8 übergeben, das von einem Staukasten 13 (vgl. Figuren 5 und 6) erzeugt wird. Oberhalb des Staukastens 13 befindet sich ein endlos umlaufendes Magnetband 11.

In den Figuren 5 und 6 sind Einzelheiten der zweiten Trocknungskammer 50 vergrößert dargestellt. Der Staukasten 13 besteht aus einer nahezu horizontalen Oberseite 18a und einer schrägen Oberseite 18b, wobei beide Oberseiten mit Lochdüsen 14 ausgestattet sind. Das Magnetband 11 läuft endlos um Umlenkwalzen 15a und 15b herum und ist im Abstand oberhalb des Staukastens 13 angeordnet. Auf dem Obertrum des Magnetbandes 11, nahe der einen Umlenkwalze 15a haften magnetische Schubelemente 9, die durch eine vertikal bewegbare Sperrklinke 10 für den Umlauf auf dem Magnetband 11 um die Umlenkwalze 15a im Takt mit den von der Papierbahn 39 an das Luftkissen 8 oberhalb des Staukastens 13 übergebenen Substraten 20 freigegeben werden. Bei dem Magnetband 11 handelt es sich um auf dem Markt erhältliche Bänder aus sogenanntem Magnetgummi, der beispielsweise aus Ferritpulver besteht, das in einem synthetischen Kautschuk eingemischt ist. Die Schubelemente 9 sind ähnlich einem liegenden T-Stück ausgebildet, wobei der Mittelteil gegenüber der Vertikalen leicht schräg gestellt ist. Während des Transports der Substrate durch die Trocknungskammer 50 haftet das einzelne Schubelement 9 an dem Untertrum des Magnetbandes 11. Der Antrieb der Substrate 20 auf dem Luftkissen 8 erfolgt durch die Schubelemente 9, welche auf dem Magnetband 11 mit umlaufen und an der Hinterkante des jeweiligen Substrats 20 anliegen. Die nahezu horizontale Oberseite 18a des Staukastens 13 ist gegenüber der Horizontalen in Transportrichtung um einen Winkel von 1 bis 2° angehoben, so daß die Hinterkante der Substrate stets an den Schubelementen 9 während des Transports anliegen. Die Tragluft wird gleichzeitig dazu benutzt, Sicherheitsbestimmungen in der Trocknungskammer 50 bezüglich Lösemittel-Konzentrationen einzuhalten, d.h. die für das Luftkissen nötige Luftmenge trägt dazu bei, daß die untere Explosionsgrenze des Lösemittel-Luft-Gemisches nicht erreicht wird.

Den hinteren Abschnitt der Trocknungskammer 50 bildet die zweite Kühlzone 21 , die auch die schräge Oberseite 18b des Staukastens 13 umfaßt, die nach unten in Richtung des Ablagekastens 19 für die Substrate 20 führt.

Der Sensor 6b nahe der Umlenkwalze 15a erfaßt die Vorderkante eines Substrats 20, das auf der Papierbahn 39 herangefördert wird, und löst die Sperrklinke 10 aus, so daß ein Schubelement 9 mit dem Magnetband 11 in einer Weise herangeführt wird, daß ein Schubelement 9 an der Hinterkante des inzwischen an das Luftkissen 8 übergebenen Substrats 20 anliegt und den Vortrieb des Substrats in Pfeilrichtung bewirkt.

Figur 7 zeigt einen Schnitt durch eine Saugwalze 5 mit einer Polygonoberfläche 5a, die sich aus einer Anzahl von Segmenten mit einer Segmentlänge s zusammensetzt. Die Segmentlänge s ist zweckmäßigerweise gleich der halben kleinsten Substratlänge, um sicherzustellen, daß ein um die Saugwalze 5 in der Wendestation herumgeführtes Substrat 20 ausreichend an der Polygonoberfläche haftet. Wie schon weiter oben erwähnt wurde, kann die Saugwalze 5 auch zylindrischen Umfang haben, wobei dann der Radius des Zylinders größer/gleich der größten Substratlänge gewählt wird. Zweckmäßigerweise wird dann die Saugwalze 5 im Inneren so ausgestaltet, daß der erforderliche Unterdruck nicht im gesamten Volumen der Saugwalze hergestellt wird, sondern nur in einem Abschnitt 5b, der sich als sichelförmiger Dichtsegment-Kasten über den halben Innenumfang der Saugwalze 5 erstreckt (vgl. Fig. 3).

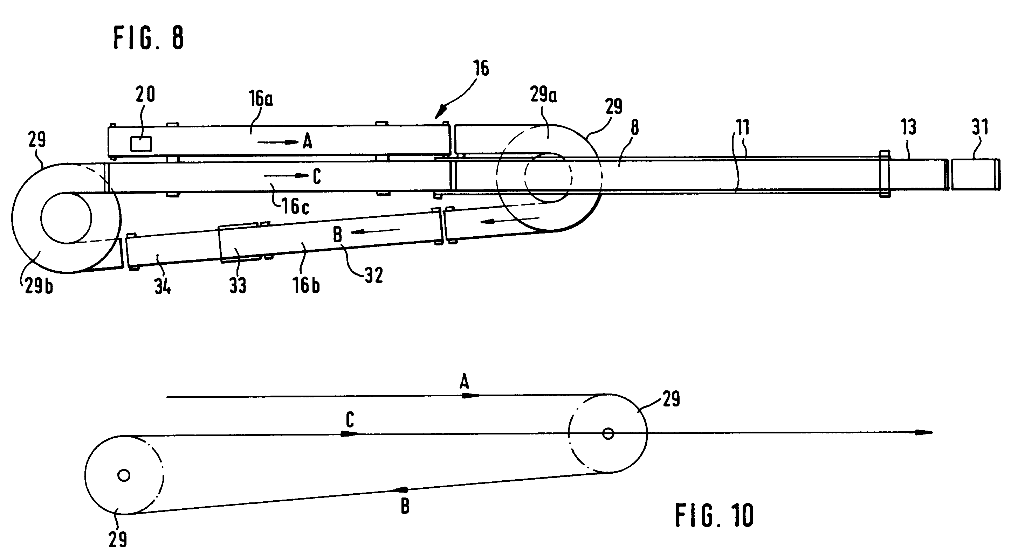

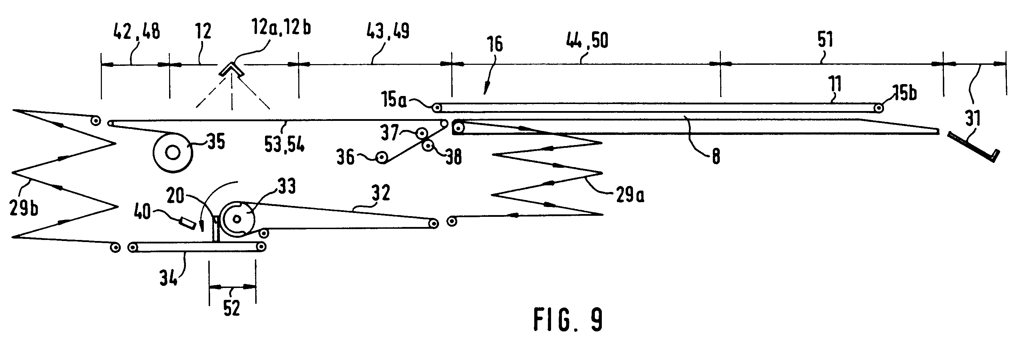

In den Figuren 8 und 9 ist eine weitere Ausführungsform einer Vorrichtung 16 nach der Erfindung dargestellt. Die Funktionsweise dieser Vorrichtung 16 entspricht weitgehend der von der Vorrichtung 1. Die Vorrichtung 16 umfaßt drei Transportlinien 16a, 16b und 16c, wobei Förderstationen 29 die erste mit der zweiten Transportlinie und die zweite mit der dritten Transportlinie verbinden. Bei diesen Förderstationen 29 handelt es sich um sogenannte Serpentinenförderer 29a und 29b. Die erste und die dritte Transportlinie sind parallel und nebeneinander in einer Ebene angeordnet, während die zweite Transportlinie 16b unterhalb dieser Ebene liegt und gegenüber der Richtung der ersten und dritten Transportlinie schräg gestellt ist. In den Figuren 8 und 9 sind übereinstimmende Baugruppen mit der Ausführungsform nach den Figuren 1 bis 4 mit den gleichen Bezugszahlen belegt, und sie werden zur Vermeidung von Wiederholungen nicht nochmals beschrieben.

Die erste Transportlinie 16a umfaßt die Aufgabe- und Reinigungsstation 42, die Sprühstation 12 mit einer Sprüheinrichtung 12a und die Antrocknungszone 43. Eine Papierbahn 53 wird von einer Abwickelrolle 35 abgezogen und horizontal durch die Reinigungsstation 42, die Sprühstation 12 und die Antrocknungszone 43 über zwei Umlenkrollen geführt. Anschließend läuft die Papierbahn 53 durch den Spalt zweier Transportwalzen 37 und 38 hindurch und wird auf eine Aufwickelrolle 36 aufgewickelt. Das in der Aufgabe- und Reinigungsstation 42 aufgelegte Substrat wird von der Papierbahn 53 an den Serpentinenförderer 29a übergeben, der das auf der Oberseite beschichtete und angetrocknete Substrat nach unten auf die zweite Transportlinie 16b befördert. Dabei wird die Förderrichtung A des Substrats in die Förderrichtung B um etwa 180° gedreht. Die zweite Transportlinie 16b umfaßt ein gelochtes schräges Förderband 32, das endlos um eine Saugwalze 33 herumgeführt ist. Diese Saugwalze 33 ist Bestandteil einer Wendestation 52, die analog zu der Wendestation 46 in Fig. 1 aufgebaut ist und genauso wie diese funktioniert. Das durch einen Druckluftstoß in der Saugwalze 33 oder einen entsprechenden Druckluftstoß der Luftdüse 40 gekippte Substrat bzw. um 180° gewendete Substrat wird von einem endlos umlaufenden, horizontalen Förderband 34 in Richtung auf den zweiten Serpentinenförderer 29b weitertransportiert. Durch den Serpentinenförderer 29b wird das Substrat auf die Ebene der dritten Transportlinie 16c angehoben und gleichzeitig aus der Förderrichtung B in die Förderrichtung C, die parallel zur Förderrichtung A ist, um etwa 180° gedreht. Die dritte Transportlinie 16c besteht aus der zweiten Reinigungsstation 48, der Sprühstation 12 mit einer Sprüheinrichtung 12b, der zweiten Antrocknungszone 49, der zweiten Trocknungskammer 50, einer Abkühlzone 51 und einem Ablagekasten 31 für die beidseitig beschichteten Substrate. Die zweite Trocknungskammer 50 sowie die zweite Abkühlzone 51 wurden anhand der Ausführungsform der Vorrichtung nach den Figuren 1 bis 4 ausführlich beschrieben, so daß hier von einer neuerlichen Beschreibung abgesehen wird.

Figur 10 zeigt schematisch den Materialfluß der Substrate durch die Vorrichtung 16, die gegenüber der Vorrichtung 1 kompakter gebaut ist.

## Patentansprüche

1. Verfahren zum elektrostatischen Aufsprühen einer Flüssigkeitsschicht auf ein Substrat (20) und zum Trocknen der Flüssigkeitsschicht auf dem Substrat, das während des Aufbringens und Trocknens der Flüssigkeitsschicht horizontal transportiert wird, wobei eine Seite des Substrats (20), das in Förderrichtung A transportiert wird, mit Flüssigkeit besprüht und getrocknet wird, dadurch gekennzeichnet, daß das Substrat in eine zur ursprünglichen Förderrichtung entgegengesetzte Förderrrichtung B herumgeführt wird, daß das Substrat (20) in der Förderrichtung B in der Vertikalen um 180 ° gewendet wird, so daß die andere Seite des Substrats nach oben weist, daß aus dieser Förderrichtung B in eine zur ursprünglichen Förderrichtung A des Substrats parallele Förderrichtung C gewechselt, die andere Seite mit Flüssigkeit besprüht, getrocknet und danach das beidseitig beschichtete und getrocknete Substrat abgelegt wird und daß alle Änderungen der Förderrichtungen und das Wenden des Substrats im vollkontinuierlichen Durchlauf erfolgen.

2. Verfahren nach Anspruch 1, dadurch gekennzeichnet, daß das Substrat (20) drei Transportlinien (1a, 1b, 1c; 16a, 16b, 16c) einer Vorrichtung (1; 16) durchläuft, wobei von der ersten zur zweiten und von der zweiten zur dritten Transportlinie jeweils beim Durchlaufen einer ersten und zweiten Förderstation (3; 29) die Förderrichtung gewechselt wird.

3. Verfahren nach Anspruch 2, dadurch gekennzeichnet, daß in der dritten Transportlinie (1c; 16c) das Substrat (20) durch eine Trockenkammer (50) auf einem Luftkissen (8) freischwebend und an einem Ende angeschoben hindurchgeführt wird.

4. Verfahren nach Anspruch 3, dadurch gekennzeichnet, daß im Bereich der zweiten Trocknungskammer (50) die Förderrichtung C des Substrats gegenüber der Horizontalen um einen Winkel von 1 bis 2° ansteigt.

5. Verfahren nach Anspruch 1, dadurch gekennzeichnet, daß das Substrat (20) drei Transportlinien (16a, 16b, 16c) der Vorrichtung (16) durchläuft, von denen die erste und dritte Transportlinie (16a, 16c) nebeneinander in einer Horizontalebene sich befinden und die zweite Transportlinie (16b) unterhalb der ersten Transportlinie (16a) liegt und daß beim Übergang des Substrats von der ersten auf die zweite und von der zweiten auf die dritte Transportlinie jeweils als Förderstation (29) ein Serpentinenförderer (29a, 29b) durchlaufen wird.

6. Verfahren nach Anspruch 5, dadurch gekennzeichnet, daß die Flüssigkeitsschicht des Substrats (20) in dem einen Serpentinenförderer (29a), der von der ersten zur Zweiten Transportlinie führt, während des Durchlaufs des Substrats getrocknet wird.

7. Vorrichtung zur Durchführung des Verfahrens nach einem der Ansprüche 1 bis 6, mit zumindest einer Sprühstation (12), die mit einem Anschluß eines Hochspannungsgenerators verbunden ist, und mit Förderbändern (2,4,7) zum Transportieren eines Substrats (20) durch die einzelnen Stationen und Kammern der Vorrichtung, dadurch gekennzeichnet, daß die Vorrichtung (1; 16) aus einer ersten bis dritten Transportlinie (1a, 1b, 1c; 16a, 16b, 16c) besteht, die durch Förderstationen (3a, 3b; 29a, 29b) miteinander verbunden sind, daß in der ersten und dritten Transportlinie (1a, 1c; 16a, 16c) je eine Reinigungsstation (42; 48), eine Sprühstation (12) mit einer Sprüheinrichtung (12a, 12b) zum Aufsprühen der Flüssigkeitsschicht, eine Antrocknungszone (43, 49) und eine Trocknungskammer (44; 50) hintereinander angeordnet sind, und daß in der zweiten Transportlinie (1b; 16b) eine Wendestation (46; 52) vorhanden ist, die das Substrat (20) in der Vertikalen um 180° wendet, so daß die Substratunterseite nach oben zu liegen kommt.

8. Vorrichtung nach Anspruch 7, dadurch gekennzeichnet, daß die erste Transportlinie (1a) für den Transport des Substrats (20) eine Papierbahn (30) aufweist, daß für den Abzug der Papierbahn eine Abwickelrolle (21) und eine erste Umlenkrolle (17a) vorhanden sind, über die die Papierbahn horizontal durch die erste Reinigungsstation (42), erste Sprühstation (12) und erste Antrocknungszone (43) hindurchführbar sowie über eine zweite Umlenkrolle (17b) und durch ein Transportwalzenpaar (23,24) hindurch auf eine Aufwickelrolle (22) aufwickelbar ist.

9. Vorrichtung nach Anspruch 7, dadurch gekennzeichnet, daß die Förderstationen (3) aus halbkreisförmigen Gurtförderern (3a, 3b) bestehen, die die erste (1a) mit der zweiten Transportlinie (1b) und die zweite (1b) mit der dritten Transportlinie (1c) verbinden, daß der erste Gurtförderer (3a) einen größeren Durchmesser als der zweite Gurtförderer (3b) hat und daß zwei Transportlinien parallel nebeneinander auf gleicher Höhe angeordnet sind.

10. Vorrichtung nach Anspruch 7, dadurch gekennzeichnet, daß die zweite Transportlinie (1b) aus einer ersten Kühlzone (45), der vertikalen Wendestation (46) und einer Transportzone (47) in einem gemeinsamen, mit reiner gekühlter Luft beaufschlagten Kanal (41) besteht, daß die Kühlzone (45) ein gelochtes, endlos umlaufendes Förderband (4) umfaßt, das um eine Saugwalze (5) herumgeführt ist, die Bestandteil der Wendestation (46) ist, zu der ein Sensor (6a) nahe der Saugwalze gehört, der die Vorderkante des Substrats (20) erfaßt und in der Saugwalze (5) oder in einer schräg oberhalb der Saugwalze befindlichen Luftdüse (40) einen Druckluftstoß auslöst, der das um die Umfangsfläche der Saugwalze herumgeführte Substrat überkippt bzw. wendet, und daß die Transportzone (47) aus einem endlos umlaufenden, mit leichter Steigung von unterhalb der Wendestation (46) nach oben zu dem zweiten Gurtförderer (3b) gerichteten Förderband (7) besteht.

11. Vorrichtung nach Anspruch 10, dadurch gekennzeichnet, daß die Saugwalze (5) eine Polygonoberfläche (5a) mit einer Segementlänge (s) gleich der halben kleinsten Substratlänge besitzt.

12. Vorrichtung nach Anspruch 10, dadurch gekennzeichnet, daß die zylindrische Saugwalze (5) einen Radius größer/gleich der größten Substratlänge aufweist.

13. Vorrichtung nach Anspruch 7, dadurch gekennzeichnet, daß die dritte Transportlinie (1c) für den Transport des Substrats (20) eine Papierbahn (39) aufweist, daß für den Abzug der Papierbahn eine Abwickelrolle (25) und eine erste Umlenkrolle (17a) vorhanden sind, über die die Papierbahn horizontal durch die zweite Reinigungsstation (48), zweite Sprühstation (12) und zweite Antrocknungszone (49) hindurchführbar sowie über eine zweite Umlenkrolle (17b) und durch ein Transportwalzenpaar (27, 28) hindurch auf eine Aufwickelrolle (26) aufwickelbar ist.

14. Vorrichtung nach den Ansprüchen 7 und 13, dadurch gekennzeichnet, daß die zweite Trocknungskammer (50) einen Staukasten (13) mit einer horizontalen (18a) und schrägen Oberseite (18b) mit Lochdüsen (14) in den Oberseiten (18a, 18b) für Tragluft und ein um Umlenkwalzen (15a, 15b) endlos umlaufendes Magnetband (11) aufweist, das im Abstand oberhalb des Staukastens (13) angeordnet ist und daß auf dem Obertrum des Magnetbandes (11) nahe der einen Umlenkwalze (15a) Schubelemente (9) magnetisch haften, die durch eine vertikal bewegbare Sperrklinke (10) für den Umlauf um die Umlenkwalze (15a) im Takt mit den von der Papierbahn (39) an das Luftkissen (8) oberhalb des Staukastens (13) übergebenen Substraten (20) freigegeben werden und an den Hinterkanten der Substrate anliegen, wobei die Schubelemente (9) an dem Untertrum des Magnetbandes während des Substrattransports durch die Trocknungskammer (50) haften.

15. Vorrichtung nach Anspruch 14, dadurch gekennzeichnet, daß die Oberseite (18a) des Staukastens (13) gegenüber der Horizontalen in Transportrichtung um einen Winkel von 1° bis 2° angehoben ist, so daß die Hinterkanten der Substrate stets an den Schubelementen (9) während des Transports anliegen.

16. Vorrichtung nach Anspruch 14, dadurch gekennzeichnet, daß die schräge Oberseite (18b) des Staukastens (13) nach unten in Richtung eines Ablagekastens (19) für die Substrate weist.

17. Vorrichtung nach Anspruch 7, dadurch gekennzeichnet, daß die Förderstationen (29) aus Serpentinenförderern (29a, 29b) bestehen, die die erste (16a) mit der zweiten Transportlinie (16b) und die zweite (16b) mit der dritten Transportlinie (16c) verbinden, daß die erste und dritte Transportlinie parallel und nebeneinander in einer Ebene angeordnet sind und daß die zweite Transportlinie (16b) unterhalb dieser Ebene liegt und gegenüber der Richtung der ersten und dritten Transportlinie schräg gestellt ist.

18. Vorrichtung nach Anspruch 17, dadurch gekennzeichnet, daß die Serpentinenförderer (29a, 29b) die besprühten und angetrockneten Substrate (20) jeweils um etwa 180 °C gegenüber ihrer jeweiligen Förderrichtung drehen.

## Claims

1. A process for electrostatically spraying a liquid coating onto a substrate (20) and for drying the liquid coating on the substrate which is conveyed in the horizontal direction during the application and drying of the liquid coating, whereby one surface of the substrate (20), which is conveyed in the direction of transport A, is sprayed with liquid and dried, characterized in that the original direction of transport A is changed into a direction of transport B which runs counter to direction A, that the substrate (20) is turned through 180° in the vertical direction so that the other surface of the substrate points upwardly, that said direction of transport B is changed into a direction of transport C extending parallel to the original direction of transport A of the substrate, that the other surface of the substrate is sprayed with liquid and dried and that the dried substrate, carrying a double-sided coating, is deposited, and that all changes of the directions of transport and the turning-over of the substrate are performed in continuous operation cycles.

2. The process as claimed in claim 1, wherein the substrate (20) is conveyed through three transport lines (1a, 1b, 1c; 16a, 16b, 16c) of a device (1; 16), whereby the direction of transport is changed between the first and the second transport line and between the second and the third transport line during the passage of the substrate through a first and a second conveying station (3; 29).

3. The process as claimed in claim 2, wherein in the third transport line (1c; 16c) the substrate (20) is conveyed through a drying chamber (50) while being freely floating on an air cushion (8) and pushed at one end.

4. The process as claimed in claim 3, wherein in the region of the second drying chamber (59) the conveying direction C of the substrate has an upward inclination of 1° to 2° relative to the horizontal.

5. The process as claimed in claim 1, wherein the substrate (20) is conveyed through three transport lines (16a, 16b, 16c) of the device (16), the first and the third transport line (16a, 16c) being arranged side-by-side in one horizontal plane and the second transport line (16b) being located below the first transport line (16a), and wherein the substrate is conveyed on conveying stations (29) designed as serpentine-type conveyors (29a, 29b) during the passage from the first to the second transport line and during the passage from the second to the third transport line.

6. The process as claimed in claim 5, wherein the liquid coating present on the substrate (20) is dried in one serpentine-type conveyor (29a), connecting the first and the second transport line, while the substrate is being conveyed through.

7. A device for performing the process as claimed in any of claims 1 to 6, comprising at least one spraying station (12) connected to a lead of a high-voltage generator, and comprising conveyor belts (2, 4, 7) for transporting the substrate (20) through the individual stations and chambers of the device, characterized in that the device (1; 16) is comprised of a first through a third transport line (1a, 1b, 1c; 16a, 16b, 16c), which are mutually connected by conveying stations (3a, 3b; 29a, 29b), that a cleaning station (42, 48), a spraying station (12) comprising a spraying appliance (12a, 12b) for applying the liquid coating, an initial drying zone (43; 49) and a drying chamber (44; 50) are sequentially arranged in the first transport line (1a; 16a) and in the third transport line (1c; 16c), and that a turn station (46; 52) is provided in the second transport line (1b; 16b), where the substrate (20) is turned vertically through 180°, so that the underside of the substrate is turned upside.

8. The device as claimed in claim 7, wherein the first transport line (1a) for transporting the substrate (20) comprises a paper web (30), wherein, for unwinding the paper web, a supply roll (21) and a first deflection roller (17a) are provided, over which the paper web can be conveyed horizontally through the first cleaning station (42), the first spray station (12) and the first initial drying station (43), and whereby, via a second deflection roller (17b) and passing through a pair of transport rollers (23, 24), the paper web can be wound onto a take-up roll (22).

9. The device as claimed in claim 7, wherein the conveying stations (3) are comprised of semi-circular belt-type conveyors (3a, 3b) which connect the first transport line (1a) with the second transport line (1b) and the second transport line (1b) with the third transport line (1c), wherein the diameter of the first belt-type conveyor (3a) is greater than the diameter of the second belt-type conveyer (3b), and wherein two transport lines are provided side-by-side in parallel alignment relative to one another and in the same plane.

10. The device as claimed in claim 7, wherein the second transport line (1b) is comprised of a first cooling zone (45), the vertical turn station (46) and a transport zone (47), which are arranged in one common tunnel (41), to which pure cooled air is supplied; wherein the cooling zone (45) comprises a punched, endlessly rotating conveyor belt (4) guided about a suction roller (5) which is part of the turn station (46), the turn station furthermore comprising a probe (6a) located close to the suction roller, which probe detects the leading edge of the substrate (20) and releases a jet of compressed air, which is blown either through the suction roller (5) or through an air nozzle (40) arranged at an oblique angle above the suction roller and by which the substrate being conveyed over the circumferential surface of the suction roller is tilted over or turned upside down; and wherein the transport zone (47) is comprised of an endlessly rotating conveyor belt (7) running with a slight upward inclination from a point below the turn station (46) up to the second belt-type conveyor (3b).

11. The device as claimed in claim 10, wherein the suction roller (5) has a polygonal surface (5a) having a segment length (5) corresponding to one half of the shortest substrate length.

12. The device as claimed in claim 10, wherein the radius of the cylindrical suction roller (5) is greater than/equal to the longest substrate length.

13. The device as claimed in claim 7, wherein the third transport line (1c) ofr transporting the substrate (20) comprises a paper web (30), wherein, for unwinding the paper web, a supply roll (25) and a first deflection roller (17a) are provided, over which the paper web can be conveyed horizontally through the second cleaning station (48), the second spray station (12) and the second initial drying station (49), and whereby, via a second deflection roller (17b), and passing through a pair of transport rollers (27, 28), the paper web can be wound onto a take-up roll (22).

14. The device as claimed in claims 7 and 13, wherein the second drying chamber (50) comprises a dynamic air pressure box (13) having a horizontal (18a) upper surface and an oblique (18b) upper surface, slot nozzles (14) for supporting air being provided in both surfaces (18a, 18b), and a magnetic belt (11) endlessly revolving about deflection rollers (15a, 15b) and being mounted above the dynamic air pressure box (13) at a distance from the latter, and wherein close to the deflection roller (15a) pushers (9) adhere magnetically to the upper strand of the magnetic belt (11), said pushers being released by a vertically shiftable catch (10) so that they are able to rotate about the deflection roller (15a), synchronously with the substrates (20) delivered from the paper web (39) to the air cushion (8) above the dynamic air pressure box, and are adjacent to the rear edges of the substrates, the pushers (9) adhering to the lower strand of the magnetic belt (11) during the transport of the substrates through the drying chamber (50).

15. The device as claimed in claim 14, wherein the upper surface (18a) of the accumulator box (13) has an upward inclination of 1° to 2° relative to the horizontal, seen in the direction of transport, so that during the transport the rear edges of the substrates are always adjacent to the pushers (9).

16. The device as claimed in claim 14, wherein the oblique surface (18b) of the accumulator box (13) is inclined downwardly in the direction of a deposition tray (19) for the substrates.

17. The device as claimed in claim 7, wherein the conveying stations (29) are serpentine-type conveyors (29a, 29b) which connect the first transport line (16a) to the second transport line (16b) and the second transport line (16b) to the third transport line (16c), wherein the first and the third transport line are provided in one plane side-by-side in parallel alignment relative to one another, and wherein the second transport line (16b) is located below that plane and extends at an oblique angle relative to the first and the third transport line.

18. The device as claimed in claim 17, wherein the sprayed and initially dried substrates (20) are turned through about 180°, relative to their respective original directions of transport, by each of the serpentine-typoe conveyors (29a, 29b).

## Revendications

1. Procédé de pulvérisation électrostatique d'une couche de liquide sur un substrat (20) et de séchage de la coche de liquide sur le substrat, lequel est transporté horizontalement pendant l'application et le séchage de la couche de liquide, une face du substrat (20), qui est transporté dans une direction de transport A, recevant la pulvérisation de liquide et étant soumise au séchage, caractérisé en ce qu'on envoit le substrat, d'une manière guidée, dans une direction de transport B opposée à la direction initiale de transport, en ce qu'on retourne le substrat (20) de 180° dans le sens vertical suivant la direction de transport B, d'une façon telle que l'autre face du substrat est tournée vers le haut, en ce qu'en passant de cette direction de transport B à une direction de transport C parallèle à la direction initiale de transport A du substrat, on soumet l'autre face à une pulvérisation de liquide et à un séchage, puis on dépose le substrat revêtu sur les deux faces et séché et en ce que tous les changements de direction de transport et le retournement du substrat ont lieu en défilement totalement continu.

2. Procédé selon la revendication 1, caractérisé en ce que le substrat (20) parcourt trois lignes de transport (1a, 1b, 1c; 16a,16b, 16c) d'un dispositif (1; 16), la direction de transport changeant de la première ligne de transport à la seconde et de la seconde à la troisième respectivement à l'occasion de la traversée d'un premier poste de transport et de celle d'un second poste de transport (3 ; 29).

3. Procédé selon la revendication 2, caractérisé en ce que, dans la troisième ligne de transport (1c ; 16c), on fait traverser une chambre de séchage (50) au substrat (20) d'une manière guidée, d'une façon telle qu'il soit librement flottant sur un coussin d'air (8) en étant poussé à une extrémité.

4. Procédé selon la revendication 3, caractérisé en ce que, dans la zone de la seconde chambre de séchage (50), la direction de transport C du substrat fait un angle de 1 à 2° vis-à-vis de l'horizontale.

5. Procédé selon la revendication 1, caractérisé en ce que le substrat (20) parcourt trois lignes de transport (16a, 16b, 16c) du dispositif (16) dont la première (16a) et la troisième (16c) sont situées l'une à côté de l'autre dans un plan horizontal, tandis que la deuxième ligne de transport (16b) est située au-dessous de la première ligne de transport (16a), et en ce que, lorsque le substrat passe de la première à la deuxième ligne de transport et de la deuxième à la troisième, c'est chaque fois un transporteur hélicoïdal (29a, 29b) qui est parcouru en tant que poste de transport (29).

6. Procédé selon la revendication 5, caractérisé en ce que la couche de liquide du substrat (20) est séchée, pendant le déplacement du substrat, dans le premier transporteur hélicoïdal (29a) qui mène de la première ligne de transport à la seconde.

7. Dispositif de mise en oeuvre du procédé selon l'une des revendications 1 à 6, comprenant au moins un poste de pulvérisation (12), relié à un raccord d'une génératrice à haute tension, et des bandes transporteuses (2, 4, 7) servant à transporter un substrat (20) à travers les différents postes et chambres du dispositif, caractérisé en ce que le dispositif (1 ; 16) est constitué d'une première, une deuxième et une troisième lignes de transport (1a, 1b, 1c ; 16a, 16b, 16c) qui sont réunies entre elles par des postes de transport (3a, 3b ; 29a, 29b), en ce que, dans chacune des première et troisième lignes de transport (1a, 1c ; 16a, 16c), il est disposé, l'un derrière l'autre, un poste de nettoyage (42 ; 48), un poste de pulvérisation (12) comportant un dispositif de pulvérisation (12a, 12b) servant à pulvériser la couche de liquide, une zone de séchage initial (43, 49) et une chambre de séchage (44 ; 50) et en ce que, dans la deuxième ligne de transport (1b ; 16b), il est disposé un poste de retournement (46 ; 52) qui retourne le substrat (20) de 180° à la verticale, d'une façon telle que la face inférieure du substrat vient se placer vers le haut.

8. Dispositif selon la revendication 7, caractérisé en ce que la première ligne de transport (1a) servant au transport du substrat (20) comprend une nappe de papier (30) et en ce que, pour l'extraction de la nappe de papier, il est prévu une bobine distributrice (21) et un premier rouleau de renvoi (17a) au moyen desquels la nappe de papier peut être introduite horizontalement, d'une manière guidée, dans le premier poste de nettoyage (42), un premier poste de pulvérisation (12) et une première zone de séchage initial (43), tandis qu'au moyen d'un second rouleau de renvoi (17b) et en passant entre une paire de cylindres de transport (23, 24), elle peut être enroulée sur une bobine d'enroulement (22).

9. Dispositif selon la revendication 7, caractérisé en ce que les postes convoyeurs (3) sont constitués de convoyeurs à courroie (3a, 3b) de forme semi-circulaire qui réunissent la première ligne de transport (1a) à la deuxième (1b) et la deuxième (1b) à la troisième (1c), en ce que le premier transporteur à courroie (3a) a un diamètre plus grand que le second transporteur à courroie (3b) et en ce que deux lignes de transport sont disposées parallèlement et à la même hauteur, l'une à côté de l'autre.

10. Dispositif selon la revendication 7, caractérisé en ce que la deuxième ligne de transport (1b) est constituée d'une première zone de refroidissement (45), du poste de retournement vertical (46) et d'une zone de transport (47) qui sont situés dans un conduit (41) commun qui reçoit de l'air purifié refroidi, en ce que la zone de refroidissement (45) comprend une bande convoyeuse perforée (4) se déplaçant suivant un mouvement de révolution sans fin et guidée autour d'un cylindre d'aspiration (5) qui est une partie constitutive du poste de retournement (46) dont fait partie un détecteur (6a) qui est disposé près du cylindre d'aspiration et qui détecte le bord avant du substrat (20) et provoque, dans le cylindre d'aspiration (5) ou dans un injecteur d'air (40) disposé d'une manière inclinée au-dessus du cylindre d'aspiration, une poussée d'air comprimé qui fait basculer haut pour bas, ou retourne, le substrat qui a été guidé autour de la surface périphérique du cylindre d'aspiration, et en ce que la zone de transport (47) est constituée d'une bande transporteuse (7) qui se déplace suivant un mouvement de révolution sans fin et qui est orientée vers le haut, avec une légère inclinaison, d'une position située au-dessous du poste de retournement (46) jusqu'au second transporteur à courroie (3b).

11. Dispositif selon la revendication 10, caractérisé en ce que le cylindre d'aspiration (5) comporte une surface prismatique (5a) à section polygonale qui présente une longueur de segment (s) égale à la moitié de la longueur de substrat la plus petite.

12. Dispositif selon la revendication 10, caractérisé en ce que le cylindre d'aspiration (5) de forme cylindrique a un rayon supérieur ou égal à la longueur de substrat la plus grande.

13. Dispositif selon la revendication 7, caractérisé en ce que la troisième ligne de transport (1c) servant au transport du substrat (20) comprend une nappe de papier (39) et en ce que, pour l'extraction de la nappe de papier, il est prévu une bobine distributrice (25) et un premier rouleau de renvoi (17a) au moyen desquels la nappe de papier peut être guidée horizontalement à travers le second poste de nettoyage (48), le seconde poste de pulvérisation (12) et la seconde zone de séchage initial (49), tandis qu'elle peut s'enrouler sur une bobine d'enroulement (26) au moyen d'un second rouleau de renvoi (17b) et en passant entre une paire de cylindres de transport (27, 28).

14. Dispositif selon les revendications 7 et 13, caractérisé en ce que la seconde chambre de séchage (50) comprend un caisson de pression dynamique (13), comportant une face supérieure horizontale (18a) et une face horizontale inclinée (18), des injecteurs (14) à trou étant ménagés dans les faces supérieures (18a, 18b) pour de l'air de sustentation, et une bande magnétique (11) qui se déplace suivant un mouvement de révolution sans fin autour de rouleaux de renvoi (15a, 15b) et qui est disposée à une certaine distance au-dessus du caisson de pression dynamique (13), et en ce que des éléments pousseurs (9) adhèrent magnétiquement sur le brin supérieur de la bande magnétique (11) au voisinage du premier rouleau de renvoi (15a), ces éléments pousseurs (9) étant libérés au moyen d'un cliquet d'arrêt (10) agencé de façon à pouvoir se déplacer verticalement, afin de permettre à ces éléments pousseurs de se déplacer autour du cylindre de renvoi (15a) d'une manière synchronisée avec les substrats (20) transférés, à partir de la nappe de papier, sur le coussin d'air (8) situé au-dessus du caisson de pression dynamique (13), ces éléments pousseurs (9) prenant appui sur les bords arrière des substrats et adhérant sur le brin inférieur de la bande magnétique pendant le transport des substrats à travers la chambre de séchage (50).

15. Dispositif selon la revendication 14, caractérisé en ce que la face supérieure (18a) du caisson de pression dynamique (13) est relevée d'un angle de 1° à 2° vis-à-vis de l'horizontale dans la direction de transport, de sorte que les bords arrière des substrats sont constamment en appui sur les éléments pousseurs (9) pendant le transport.

16. Dispositif selon la revendication 14, caractérisé en ce que la face supérieure inclinée (18b) du caisson de pression dynamique (13) est orientée vers le bas en direction d'un casier (19) de dépôt des substrats.

17. Dispositif selon la revendication 7, caractérisé en ce que les postes convoyeurs (29) sont constitués de convoyeurs hélicoïdaux (29a, 29b) qui réunissent la première ligne de transport (16a) à la deuxième (16b) et la deuxième (16b) à la troisième (16c), en ce que les première et troisième lignes de transport sont disposées parallèlement et l'une à côté de l'autre dans un plan et en ce que la deuxième ligne de transport (16b) est située au-dessous de ce plan et est disposée d'une manière inclinée vis-à-vis de la direction des première et troisième lignes de transport.

18. Dispositif selon la revendication 17, caractérisé en ce que les transporteurs hélicoïdaux (29a, 29b) font pivoter chacun des substrats (20), qui a reçu la pulvérisation et a été soumis à un séchage initial, de 180° environ vis-à-vis de la direction de transport correspondante.
